Europäisches Patentamt

European Patent Office

Office européen des brevets

(19)

(11) Publication number: **0 581 409 A1**

# EUROPEAN PATENT APPLICATION

(12)

(21) Application number: **93302605.6**

(22) Date of filing: **01.04.93**

(51) Int. Cl.5: **H03K 19/177**, H03K 19/173

(30) Priority: **29.07.92 US 922286**

(43) Date of publication of application:
**02.02.94 Bulletin 94/05**

(84) Designated Contracting States:
**DE FR GB NL**

(71) Applicant: **Xilinx, Inc.**
**2100 Logic Drive**
**San Jose, California 95124(US)**

(72) Inventor: **Goetting, F. Erich**
**11659 Olive Spring Court**
**Cupertino, California 95014(US)**

(74) Representative: **Freeman, Jacqueline Carol**
**W.P. Thompson & Co.**
**High Holborn House**
**52-54 High Holborn**
**London WC1V 6RY (GB)**

(54) **Programming a field programmable gate array and reading array status.**

(57) The present invention is used in an FPGA device having programmable logic cells and a programmable interconnect array. In a preferred embodiment in which the logic cells are programmed using transistors controlled by memory cells and the interconnect structure is programmed using antifuses, a configuration control unit (CCU) of the present invention can accomplish three functions: 1) applying programming voltages to terminals of the interconnect antifuses; 2) configuring the logic cells; and 3) reading status of signals on the interconnect structure. The CCUs are connected together into a shift register. Each CCU connects to a horizontal or vertical interconnect line. At intersections of these interconnect lines are antifuses. By loading logical 1's into the two CCUs, it is possible to address the antifuse at the intersection of the two interconnect lines. A voltage difference can then be directed to the two terminals of that antifuse for programming the antifuse. After antifuses are programmed, configuration information is shifted into the CCUs to configure the logic cells. These same CCUs can be used to capture the logical states of each of the interconnect lines, each CCU capturing one signal present on an interconnect line to which that CCU connects. The captured data can then be shifted out through the shift register.

**FIG. 3**

EP 0 581 409 A1

The invention relates to a control unit and system for, and a method of, controlling configuration of logic cells and an interconnect structure of a field programmable gate array.

Programmable devices are currently available in several different architectures. Earliest of the programmable devices are the programmable logic array (PLA) devices which comprise a plurality of AND gates programmably connected to a second plurality of OR gates. These devices can generate any combinational logic function, because any combinational logic function can be written as a sum of products, the products being generated in the AND array and the sums being generated in the OR array. These two level logic devices (one AND level and one OR level) are simple to program, and it is easy to predict the time delay for generating an output. However, the silicon area needed to calculate a complex logic function can be undesirably large.

More recently, programmable logic devices called field programmable gate arrays or FPGAs have been developed. These devices comprise an array of programmable logic cells which can be interconnected by programmable interconnect lines to generate complex logic functions. In an FPGA device, a function need not be calculated as a two-level sum of products because it is possible to feed the output of any one logic cell to an input of any other logic cell, and thereby form a chain, generating a function which has multiple levels of logic. Thus it is possible to implement complex logic in a smaller physical area.

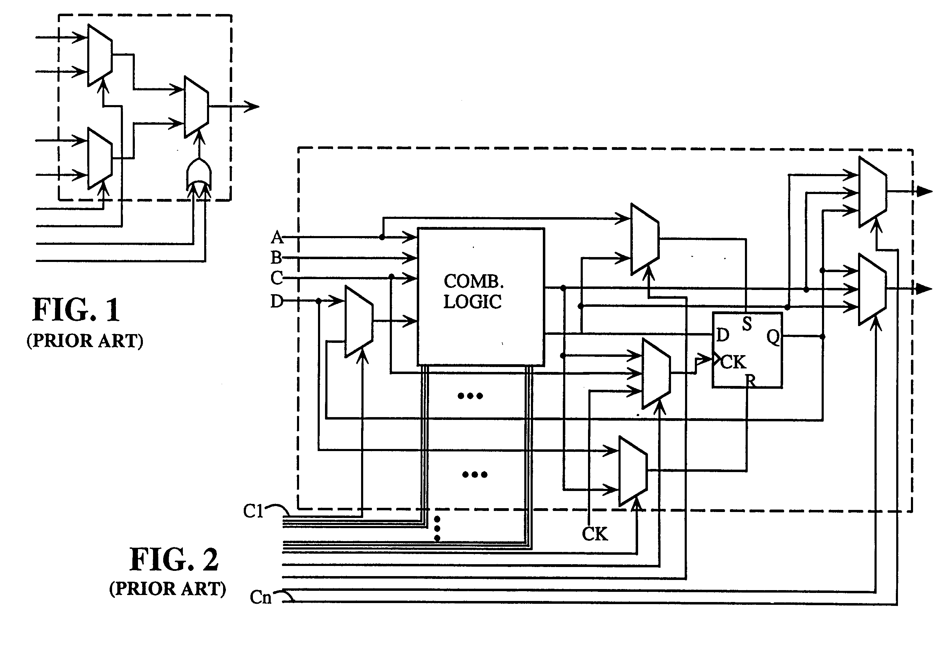

Several architectures of these field programmable logic devices are available today. The various devices differ in the complexity of a single logic cell. Examples are shown in Figures 1 & 2 of the accompanying drawings, in which:

Fig. 1 shows a prior art logic cell having a small cell size, and

Fig. 2 shows a prior art logic cell having a large cell size as used in the Xilinx 3000 series parts. Some manufacturers offer devices having logic cells such as shown in Fig. 1 which are quite small (fine grained architecture). Others offer devices having logic cells such as shown in Fig. 2 which are considerably larger and which handle larger functions within a single logic block (coarse grained architecture).

A small logic cell such as shown in Fig. 1 has the advantage of being able to be completely filled by the logic of a user, and thereby not leave unused logic resources within the cell. It may be possible to generate either combinational or sequential functions from a plurality of small logic cells. However, with fine grained architectures made up of small logic cells, it requires many logic cells to generate a complex logic function. A function which must make use of more than one logic cell must use programmable interconnect line to generate the function. When the signal path passes through resistive programmable elements, the time delay associated with capacitive and resistive interconnect line considerably slows down the response of the sequential function.

The larger celled (coarse grained) logic devices can generate complex functions quickly within a single logic block. However, if the user specifies a set of functions which do not make full use of the rather large logic cell, portions of the logic cell will be unused. Also, some of the fairly large logic cells include separate resources for generating combinational functions and for generating sequential functions. The cell of Fig. 2 is such a cell.

The cell of Fig. 2 includes some lines A through D for data input and output and some lines C1 through Cn to configure the cell to respond in particular ways to the data signals. These configuration signals C1 through Cn may be stored in memory cells, and held for some time to maintain a desired configuration.

For an FPGA device such as shown in Figs. 1 and 2, it is necessary to test the device to determine whether all components have been manufactured properly. Since these devices are highly integrated, having many repeating structures, it is necessary to use an efficient testing procedure. It is also necessary to have an efficient procedure for programming interconnections between the cells and for programming the cells to perform the desired functions.

The present invention is used in an FPGA device having programmable logic cells and a programmable interconnect array In a preferred embodiment in which the logic cells are programmed using transistors controlled by memory cells and the interconnect structure is programmed using antifuses, a configuration control unit (CCU) of the present invention can accomplish three functions:

1) applying programming voltages to terminals of the interconnect antifuses;

2) configuring the logic cells; and

3) reading status of signals on the interconnect structure.

These three functions are accomplished at different times during the life of the FPGA. Clever isolation means allow all three functions to be handled by a CCU without causing conflict.

The CCUs are connected together into a shift register. Each CCU connects to a horizontal or vertical interconnect line. At intersections of these interconnect lines are antifuses. By loading logical 1's into the two CCUs, one horizontal CCU and one vertical CCU, it is possible to address the antifuse at the intersection of the two interconnect lines. A voltage difference can then be directed to the two terminals of

2

that antifuse for programming the antifuse. While these logical 1's are present in the CCUs for programming antifuses, the logic cells which are configured by these same CCUs are all held at a high impedance output state so that they are isolated from the interconnect lines being interconnected. After antifuses in the interconnect structure have been programmed, the CCUs are loaded with configuration information to cause the cells to perform their desired functions. At this stage, the means for applying antifuse programming voltages to the interconnect structure are electrically isolated from the interconnect structure, so that signals on the interconnect lines are controlled by logic cell outputs as determined by the previously connected antifuses and by the logic cell output signals. A sequence of steps described below allows the CCUs which have been holding configuration information to capture data placed on the interconnect lines by the logic cells, shift the data out through a shift register, and then be reloaded with configuration information. Bringing cell outputs to a high impedance state must be carefully coordinated with reading interconnect data into CCUs in order to avoid destroying data which have been present on the interconnect lines.

The two logical 1's which address the horizontal and vertical CCUs and cause voltages to be applied to a corresponding horizontal line and vertical line are shifted through the shift register of CCUs. When programming voltages are applied to the device, they appear at the addressed terminals and cause the addressed antifuse to be programmed.

After all or a set of antifuses are programmed, configuration information is shifted into the CCUs to establish the configuration of the logic cells. These same CCUs can be used to capture the logical states of each of the interconnect lines, each CCU capturing one signal present on an interconnect line to which that CCU connects. The captured data can then be shifted out through the same shift register which initially shifted configuration information into the CCUs. The interconnect line status can be used for testing the array or debugging a design.

The invention is further described below, by way of example, with reference to the remaining Figures of the accompanying drawings, in which:

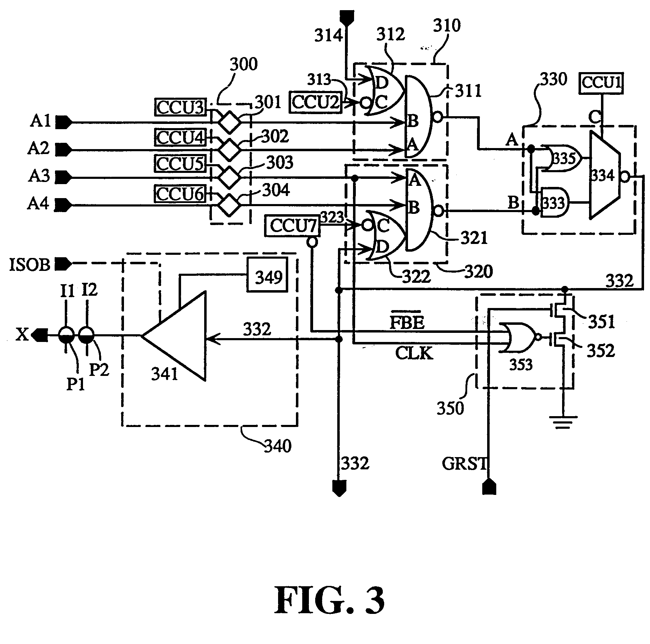

Fig. 3 shows a logic cell according to the present invention.

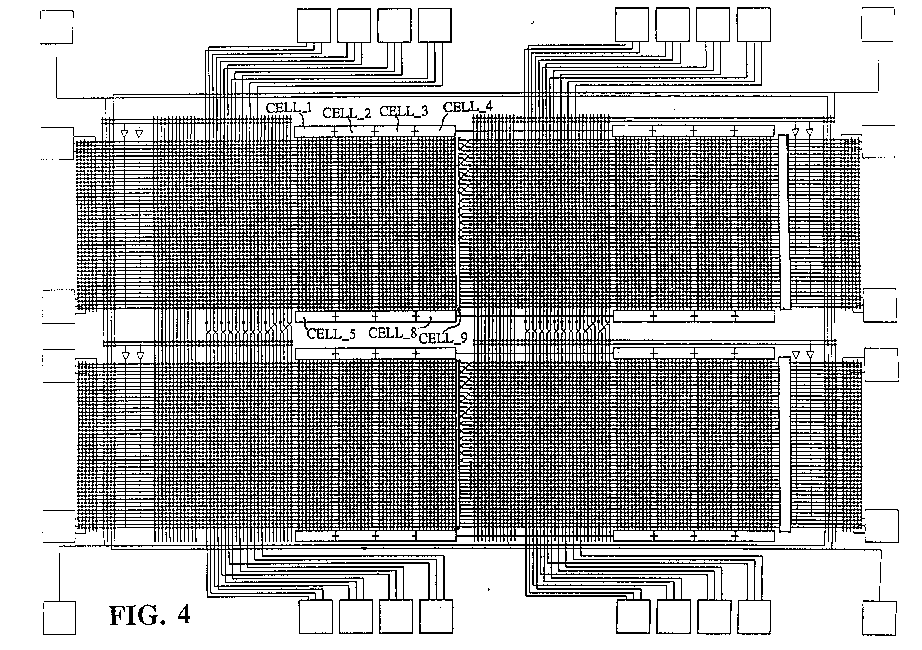

Fig. 4 shows a very small field programmable integrated circuit device made up of the cells of Fig. 3.

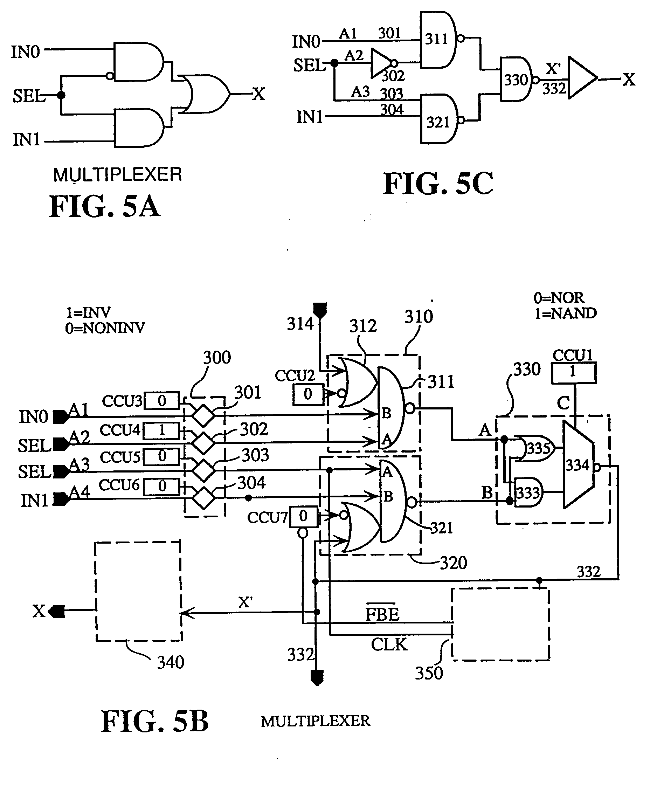

Figs. 5A and 5B show a two-input multiplexer, its implementation using the cell of Fig. 3, and Fig. 5C shows the equivalent circuit.

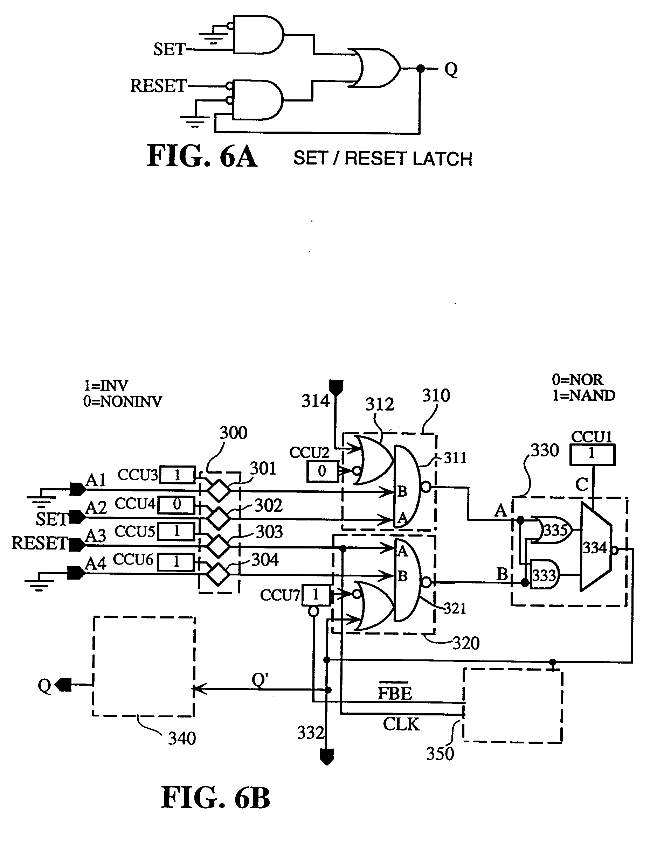

Figs. 6A and 6B show a set-reset latch and its implementation using the cell of Fig. 3.

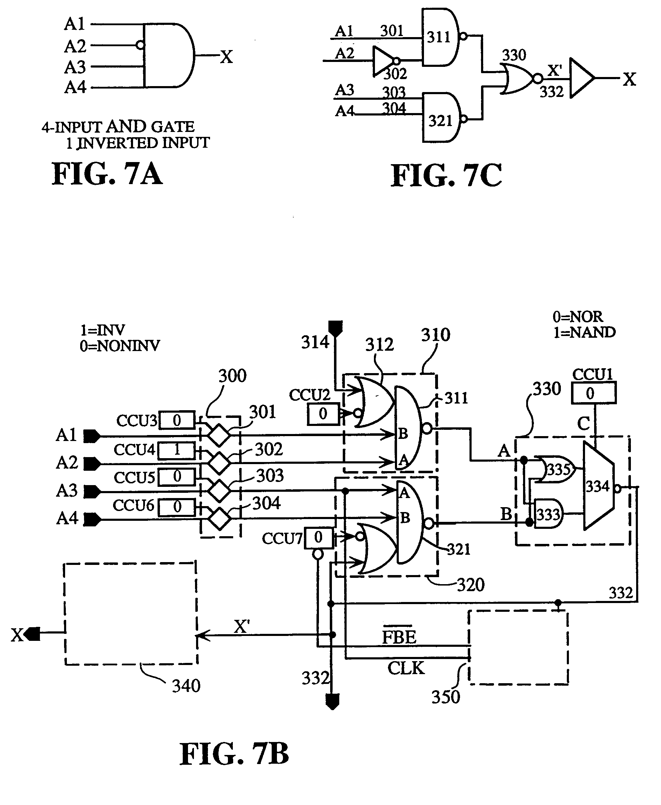

Figs. 7A and 7B show a 4-input AND gate with one inverted input, and its implementation using the cell of Fig. 3.

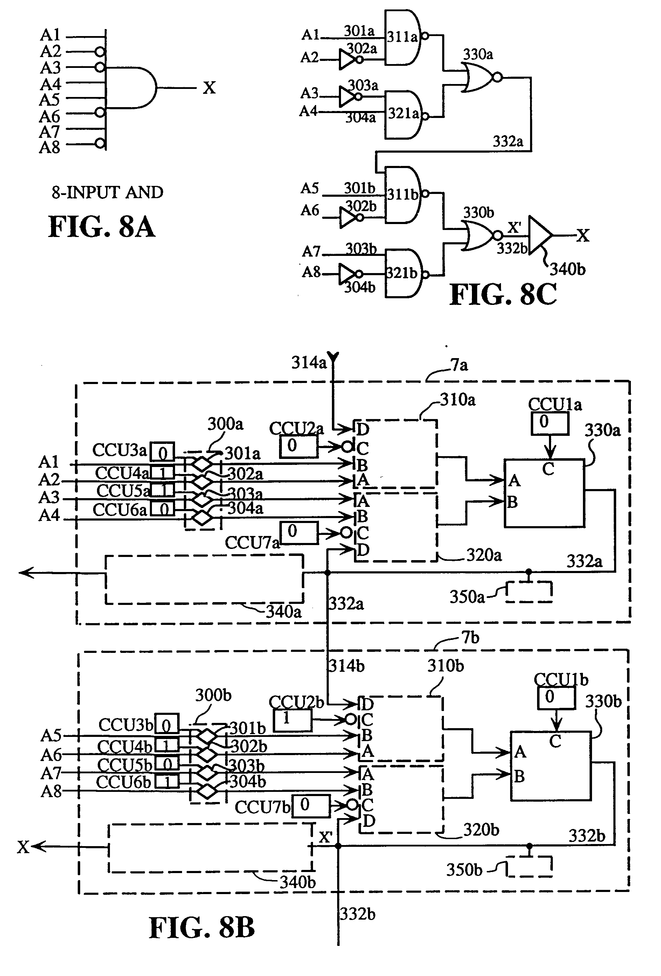

Figs. 8A and 8B show an 8-input AND gate with some inverted inputs, and its implementation using two of the cells of Fig. 3 interconnected using the cascade feature.

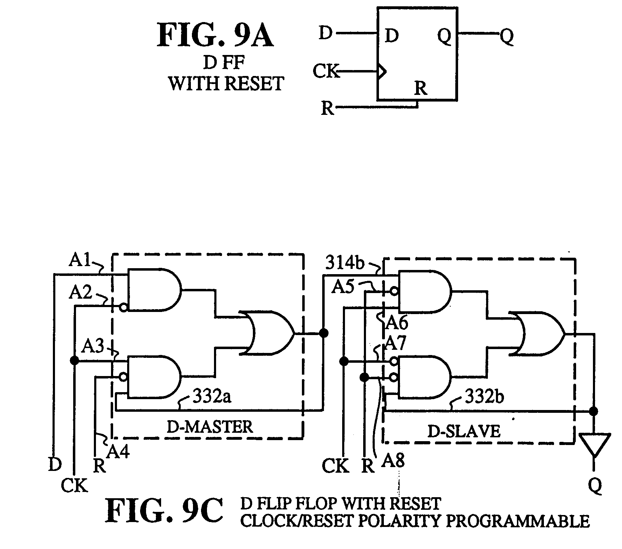

Figs. 9A-9C show a D flip flop and its implementation using two of the cells of Fig. 3 interconnected using the cascade feature, and latching using the feedback feature of the cells.

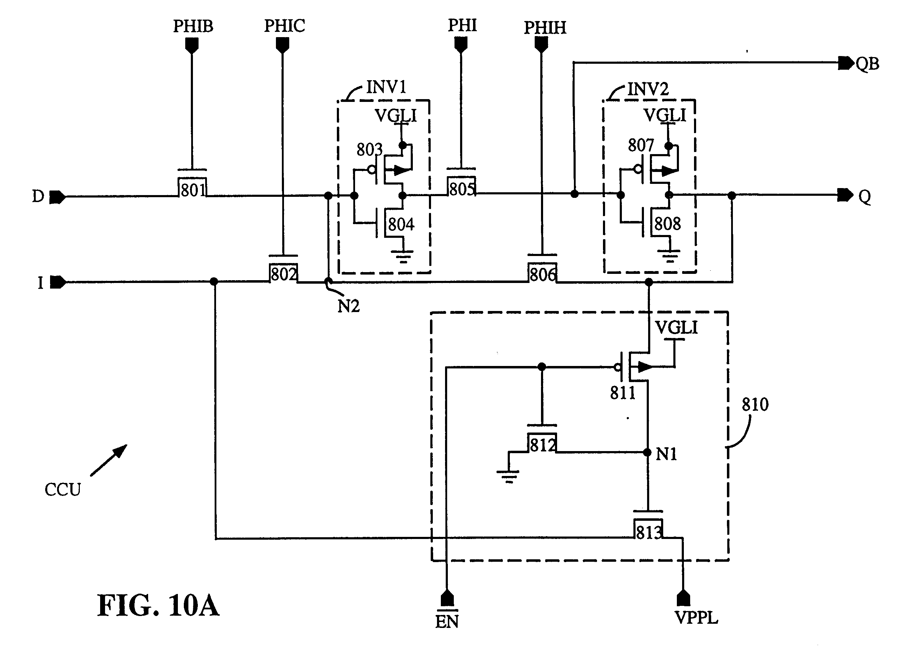

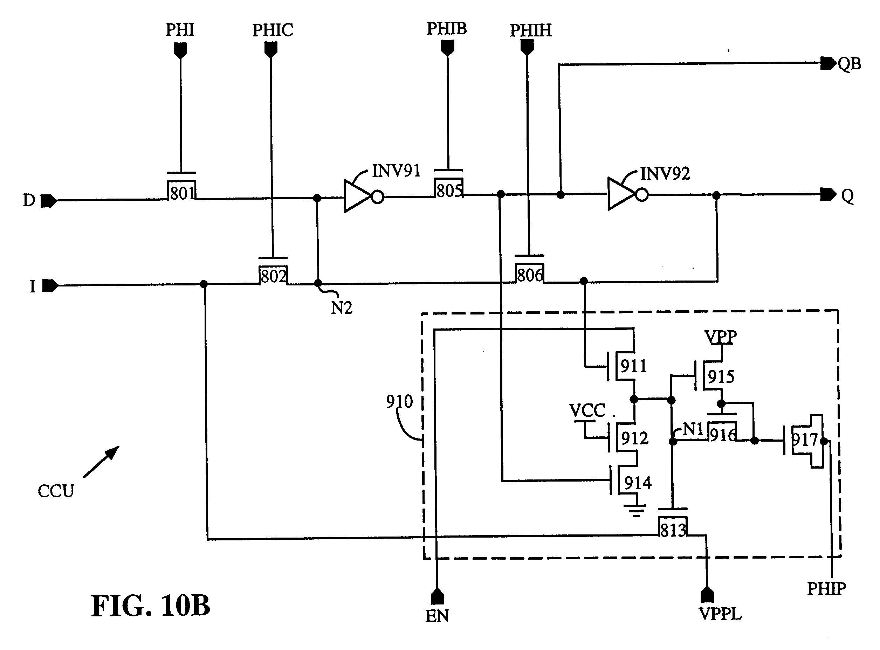

Figs. 10A and 10B show two implementations of the configuration control units such as CCU1 through CCU7 of Figs. 3 and 4.

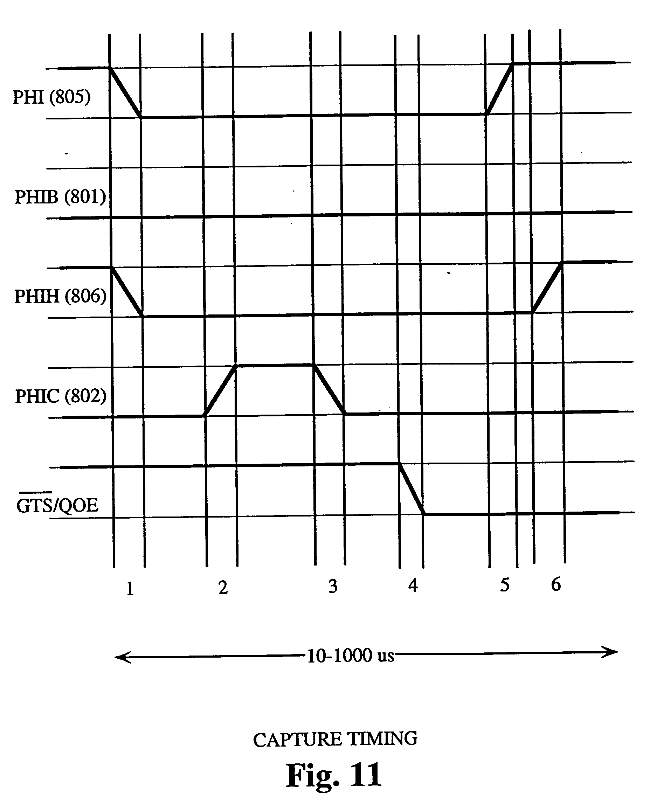

Fig. 11 shows a timing diagram when the circuit of Fig. 10A or 10B is used to capture data present on the interconnect structure for shifting out to an external device, and

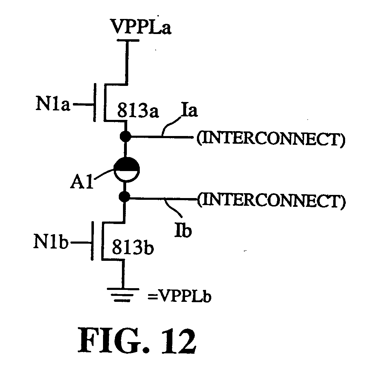

Fig. 12 represents an antifuse programming structure which uses logic cells such as shown in Fig. 3 and configuration control unit addressing means such as shown in Figs 10A and 10B.

The logic cell of Figure 3 comprises seven major sections:

(1) a programmable input inverter stage 300,

(2) a cascade-in first combinational stage 310,

(3) a feedback first combinational stage 320,

(4) a second combinational stage 330,

(5) an output driver stage 340,

(6) a selective global reset circuit 350, and

(7) a set of configuration control units CCU1 through CCU7 for controlling the configuration of the cell.

## Overview of the Seven Sections of Fig. 3

Input buffer stage 300 comprises four input buffers 301 through 304, each of which can be inverting or non-inverting as selected by the user. Providing optional inverters at every input allows the elimination of inverters at the outputs, thus combinational logic resources never need be used simply for the purpose of inverting a signal.

Cascade-in first combinational stage 310 comprises a 3-input NAND gate 311 and a 2-input OR gate 312. OR gate 312 receives a cascade enable control input 313 and a cascade input 314 from an adjacent cell. OR gate 312 provides input to NAND gate 311. Also provided as input to NAND gate 311 are outputs from selectively inverting input buffers 301 and 302.

Feedback first combinational stage 320 also comprises a three-input NAND gate 321 fed by output signals from selectively inverting input buffers 303 and 304. NAND gate 321 further receives input from OR gate 322 which receives on one of its input terminals a feedback signal 332 and on another input terminal a feedback enable control input 323.

Second combinational stage 330 can be programmed to provide a NAND or a NOR function of outputs from the cascade combinational stages 310 and 320. Second combinational stage 330 provides an output signal 332 which can be fed back by OR gate 322 to AND gate 321, can further be provided as a cascade OUT signal which becomes a cascade IN signal to an adjacent cell, and which is provided to output driver stage 340, where it can be driven onto the interconnect structure and used as input to other cells.

Output driver stage 340 includes a buffer 341 of sufficient strength to drive the output signal onto an interconnect structure represented in Fig. 3 by interconnect lines I1 and I2. The connection from a cell output to an interconnect line includes means 349 for providing a high impedance to the interconnect line. That way, an interconnect line can serve as a bus, receiving signals alternately from a plurality of sources, which is a common structure in large circuits. In one embodiment a second means ISOB provides a high impedance to the interconnect line.

Global reset circuit 350 allows the cell to be reset when used as a latch or flip flop. Circuit 350 includes means for pulling low the output 332 of second combinational stage 330 in response to a global reset signal. It is necessary to reset only the cells which are used as latches or flip flops in the array. Thus circuit 350 provides a reset voltage only when feedback stage 320 is configured as a latch, and only at the part of a clock cycle when the cell is latching and is not in the data receive mode. The circuit adds minimum capacitance when inactive and draws minimum power when resetting the array.

Configuration control units CCU1 through CCU7 are used for three purposes: first for applying programming voltages to antifuses in the interconnect structure, second for storing configuration information which configures the cell during normal operation, and third for allowing a user to capture the status of all signals on interconnect lines and shift these out of the chip to be examined by the user.

As shown in Fig. 4, the cells of Fig. 3 are preferably grouped into blocks of eight cells CELL_1 through CELL_8 with a ninth cell CELL_9 comprising a plurality of CCUs. The nine cells of a block combine with an antifuse interconnect structure (antifuses are represented by black dots) which can be programmed to interconnect the cells to each other to implement a circuit design desired by a user. Four cell blocks are shown in Fig. 4. A typical integrated circuit array will comprise 100 to 1000 of these cell blocks such as shown in Fig. 4 , plus peripheral I/O circuitry, clock oscillators, and other overhead circuitry usually positioned along the perimeter of the cell. Logic implemented in each cell CELL_1 through CELL_8 is controlled by the CCUs, as discussed below.

Example Implementations of the Circuits of Figs. 5A through 9A Shown in Figs. 5B through 9B Respectively

Figs. 5A through 7A show some of the functions which can be implemented in a single cell of Fig. 3. Figs. 5B through 7B show the configuration control bits which are applied to the cell of Fig. 3 to implement the respective functions. It can be seen by tracing the signal path through the cell of Fig. 3 that none of the functions implemented in the cell of Fig. 3 use a signal path through an antifuse or other interconnect configuration means. Thus the cell offers fast implementation of these functions.

For example, Fig. 5A shows a two-input multiplexer having two inputs. IN0 and IN1, and a select input SEL. Fig. 5B shows an implementation of this two-input multiplexer. Input IN0 is applied to line A1 and input IN1 is applied to line A4. Select input SEL is applied to lines A2 and A3. A logical 0 stored in the memory cell which controls configuration control unit CCU3 causes optional inverter 301 to be noninverting. (The configuration control units are discussed in more detail below.) Thus the value of IN0 is provided by optional inverter 301 to the B input of NAND gate 311. A logical 1 stored in the memory cell which controls configuration control unit CCU4 causes optional inverter 302 to invert the SEL select signal on line A2 and apply the inverted signal to the A input of NAND gate 311. The logical 0 controlling optional inverter 303 allows the SEL signal to be applied to the A input of NAND gate 321. Finally, the logical 0 controlling inverter 304 allows input IN1 to be passed noninverted to the B input of NAND gate 321.

Three more memory cells control the cell of the invention, as represented by CCU1, CCU2, and CCU7. A logical 0 in CCU2 is inverted at the input to OR gate 312, causing OR gate 312 to apply a high signal to NAND gate 311 regardless of the signal on line 314. Thus NAND gate 311 is configured as the logical equivalent of a two-input NAND gate, as shown in Fig. 5A. A logical 0 in CCU7, inverted at the input to NAND gate 321 disables the feedback loop, so that NAND gate 321 operates as a two-input NAND gate as shown in Fig. 5A. Finally, a logical 1 in CCU1 causes second combinational stage 330 to operate as a NAND gate. Recall that by deMorgan's theorem a NAND gate with inverted inputs is equivalent to an OR gate, thus NAND gates 311 and 321 in combination with NAND gate 330 form the AND gates and OR gate shown in Fig. 5A. Thus the circuit of Fig 3 configured as shown in Fig. 5B implements the multiplexer of Fig. 5A. The equivalent circuit is shown in Fig. 5C, with reference numerals corresponding to those of Fig. 5B.

Set/Reset Latch

Fig. 6A shows a set/reset latch which can be implemented as shown in Fig. 6B using the cell of Fig. 3.

4-Input AND Gate

Figs. 7A and 7B show a 4-input AND gate with one inverted input, and its implementation using the cell of Fig. 3. Note that second combinational stage 330 is configured as a NOR gate by a logical 0 from CCU1. With the two inverted inputs (the inverted outputs of NAND gates 311 and 321) second combinational stage provides the AND function. In the example of Fig. 7A, the A2 input is inverted. Therefore, a logical 1 in CCU4 causes optional inverter 302 to act as an inverter. Clearly any combination of inverted inputs may be selected. The equivalent circuit is shown in Fig. 7C with reference numerals corresponding to those of Fig. 7B.

Example Wide AND Function, Figs. 12A and 12B Using Cascade

Fig. 8A shows an 8-input AND gate with inputs A2, A3, A6, and A8 inverted. As shown in Fig. 8B this 8-input AND gate is implemented using two cells of Fig. 3 connected using the cascade feature. Users may cascade more than two adjacent cells together to form wider or larger functions. Lines A1 through A8 provide the eight inputs, while the AND function is provided as the X output. The logical 0 in cascade-in control unit CCU2a causes cell 7a to ignore the signal on line 314a. Optional inverter 301a is caused by a logical 0 in CCU3 to provide a noninverted version of A1. Optional inverter 302a is caused by the logical 1 in CCU4a to invert the A2 signal. Logical 1's at CCU5a, CCU4b, and CCU6b also cause inversion of A3, A6, and A8. Feedback control unit CCU7a provides a logical 1, which causes 320a to ignore Q output signal 332a. The logical 0 control signal from control unit CCU1a causes second combinational stage 330a to provide the NOR function of stages 310a and 320a. Thus, by deMorgan's theorem, the output signal placed on line 332a is the AND function of A1 through A4. Configuration control unit CCU2b carries a logical 1, which causes the cascade 332a output signal from cell 7a to be provided as input D to cascade unit 310b of cell 7b. Thus cascade unit 310b provides the NAND function of three inputs, A5, A6, and the AND output of cell 7a. Importantly, the AND output of cell 7a arrives at the input of cascade unit 310b without passing through any programmable interconnect. Thus this cascade connection reduces delay as well as saving interconnect resources. Cell 7b also has a logical 0 in CCU1b and CCU7b. The result is that the output B2 of cell 7b is an AND function of eight inputs A1 through A8. In particular,

$$B2 = A1 * \overline{A2} * \overline{A3} * A4 * A5 * \overline{A6} * A7 * \overline{A8}$$

Though the cascade path connecting output line 332a to cascade-in line 314b avoids the delay of output buffer 340a and input buffer 300b, nevertheless for maximum speed of the system using a wide AND gate such as implemented in Fig. 8B it is preferable to apply signals requiring minimum delay to inputs A5-A8 because these signals will not have to be processed through two cells before reaching the output at B2. Fig. 8C shows the equivalent circuit with reference numerals corresponding to those of Fig. 8B.

Example D Flip, Flop Figs. 9A-9C

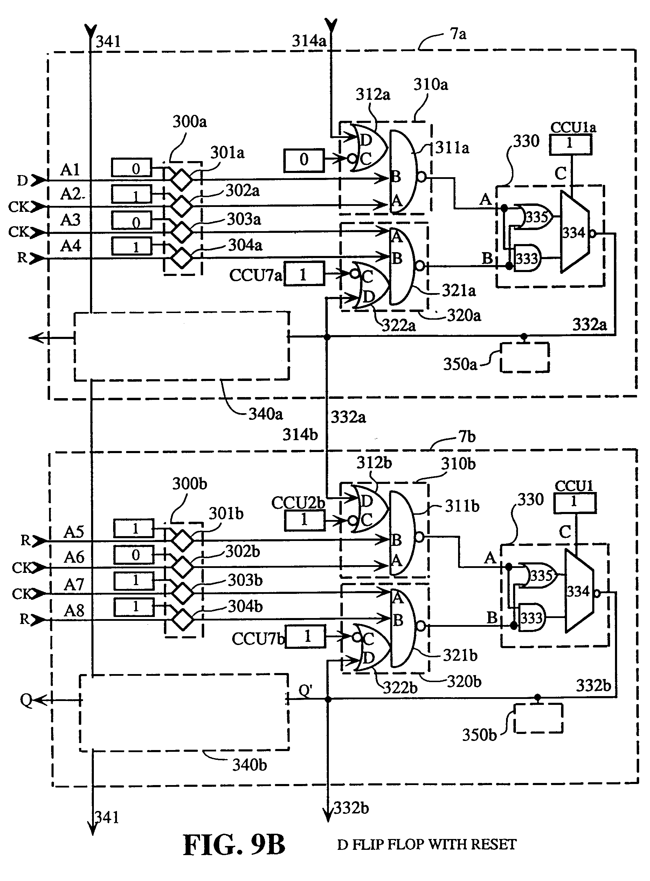

Figs. 9A, 9B, and 9C show a D flip flop and its implementation in Fig. 3. This flip flop uses two of the cells of Fig. 3, each indicated by one of the dotted lines 7a and 7b. The flip flop is formed by cascading two transparent latches. The implementation shown is only one of several ways available with a pair of cells as in Fig. 3. The D input of Fig. 9A is provided on line A1 of Fig. 9B. Clock input CK of Fig. 9A is provided on lines A2, A3, A6 and A7, and is inverted by buffers 302a and 303b but not by buffers 303a or 302b. Reset input R is provided on lines A4, A5, and A8, and inverted by all three of buffers 304a, 301b, and 304b. In both cells, second combinational stages 330a and 330b are configured as NAND gates. Cascade enable unit 312b carries a logical 1, enabling the output signal on line 332a from the master section of the flip flop to be passed by OR gate 312b to NAND gate 311b. Logical 1 signals from feedback control units CCU7a and CCU7b enable the internal feedback paths. Thus the circuit of Fig. 9B formed from two cells of Fig. 3 implements the D flip flop of Fig. 9A. Fig. 9C shows the equivalent circuit with reference numerals corresponding to those of Fig. 9B.

## Configuration control Unit. First Embodiment

Fig. 10A shows a configuration control unit CCU such as CCU1 through CCU7 used with the cell of Fig. 3. In a preferred embodiment these configuration control units serve three purposes:
(1) holding configuration information for configuring the logic cell,
(2) capturing data on status of interconnect lines for testing purposes, and
(3) applying programming voltages for programming antifuses in the interconnect structure.
These three uses of the CCU of Fig. 10A will now be explained.

## Holding configuration Information

This first function, holding information for configuring a cell, was discussed above in connection with Figs. 5A-9C. Many different cell configurations can be achieved by simply placing appropriate 1's and 0's into particular CCUs shown in Fig. 3.

In a first embodiment, the CCUs of Fig. 3 are each formed as shown in Fig. 10A. Each CCU comprises a pair of inverters INV1 and INV2, which can be connected together as a latch by turning on transistors 805 and 806 with high PHI and PHIH signals, and turning off transistors 801 and 802 with low PHIB and PHIC signals. A long string of CCUs, each as shown in Fig. 10A, are connected into a shift register by connecting the D input of one CCU to the Q output of another CCU.

## Shifting Configuration Information into Device

To shift configuration information into an integrated circuit chip of which the cell of Fig. 3 is a part, the chip is first flushed to assure that all CCUs hold logical 0. By applying high signals PHI and PHIB to all transistors 801 and 805 in the shift register, and applying logical 0 to the first D input of the first cell in the shift register, the entire shift register is set so that all Q outputs are logical 0 and all $\overline{Q}$ outputs are logical 1. Next, a sequence of configuration bits is shifted through the register by alternately turning on transistors 801 and 805 with non-overlapping high signals PHIB and PHI, with a new configuration bit entered at the D input of the first cell each time PHIB is high. During this shifting operation, low signals on PHIC and PHIH maintain transistors 802 and 806 off. When configuration data have been shifted into position, a low signal PHIB holds transistors 801 off, while high signals PHI and PHIH latch each configuration bit into its respective CCU in a static latch configuration, inverters INV1 and INV2 being connected together through transistors 805 and 806 into a static RAM cell. Each configuration bit is then available to drive appropriate nodes in the respective cell of Fig. 3. Seven configuration bits in the seven CCUs of one cell establish the selected configuration of the cell. The above shift register operation is also discussed in U.S. Patent 4,870,302, incorporated herein by reference.

Circuit 810 of Fig. 10A comprising transistors 811, 812, and 813 and signals Q, $\overline{\overline{EN}}$ and VPPL is discussed below in the section on programming antifuses. Signal I is discussed below under the section on interconnect signal capture.

## Interconnect Signal Capture

It may be desirable, especially for testing and diagnosis, to examine the signals present in portions of the chip after the chip has been configured and operating for some time. The second function of the CCU of Fig. 10A is to capture the signal present on that piece of interconnect to which the CCU is connected. As discussed above, collectively the CCUs of an array are formed as one or a few shift registers. In addition to shifting in configuration information, the CCUs can shift out information which has been captured from the interconnect line. Thus the CCUs can allow a user to examine the signal on each line which is connected to a CCU. And every signal line which provides input to one of the logic cells in the array or receives output from one of the cells of the array is in fact connected to a CCU.

A sequence of steps allows the interconnect line data to be transferred into the CCUs. The sequence of steps allows the value on line I to be substituted for the value which has been stored by INV1 and INV2 in

6

the CCU. During capture, signal $\overline{EN}$ is high, so all programming transistors 813 are off, regardless of the states of INV1 and INV2.

Fig. 10B shows an alternative embodiment of the configuration control unit of Fig. 10A.

## Timing Diagram

Fig. 11 shows a timing diagram of a preferred order of controlling signals PHI, PHIH, PHIB, PHIC and GTS in order to reliably capture the signal from an interconnect line I into a CCU without causing loss of data or contention in any parts of the array. The capture steps are as follows:

1. Bring down PHI and PHIH, turning off transistors 805 and 806, so the CCU is temporarily put into a dynamic memory state (that is, a state in which the values will only be retained temporarily). Capacitance is such that the value can be retained on the order of a millisecond, and the preferred timing is such that the cell will be held in its dynamic state on the order of 1 microsecond.

2. Next, transistor 802 is turned on with a high PHIC signal, so that the signal on interconnect line I (which can represent interconnect segments A1 through A4, Q, Z1, Z2 in Fig. 27) is applied to inverter INV1. Since transistor 806 is off, there is no contention between the dynamic signal on I being applied to inverter INV1 and the signal Q which is still (temporarily) stored in the CCU.

3. Once the signal is captured, PHIC may be brought low, turning off transistor 802. The state of signal I is now stored dynamically on node N2.

4. Since the cell configuration will soon be overwritten by the captured data, and contention between certain cell outputs could occur, all outputs of the cells of Fig. 3 or Fig. 4 are brought to a high impedance condition. High impedance of output signals must occur before transistor 805 is next turned on by a high signal PHI.

5. After the corresponding interconnect signal has been applied to INV1 and cell outputs have been brought to high impedance, a high signal PHI is applied and transistor 805 is turned on, and thus the captured I signal (inverted) is applied to INV2.

If not done earlier, transistor 802 is turned off by bringing PHIC low, isolating the CCU from the interconnect I.

6. PHIH is then brought high, turning on transistor 806, and latching the signal which was on I into the static memory cell formed by INV1, 805, INV2 and 806.

At this point, the CCUs of the array no longer contain configuration information, but instead contain the signals present on their respective interconnect line segments. Since the CCUs are connected into a shift register, the signals may be shifted out using the same sequence as described above for shifting the configuration signals in. As interconnect data are being shifted out, configuration data are simultaneously shifted into position to again reconfigure the cell. Alternately, the shifting out of interconnect information and shifting in of configuration information may be done in separate steps.

## Programming antifuses

Configuration of a chip requires that not only are the cells configured to perform the desired function, but that the interconnect structure is also programmed to interconnect the cells to each other as desired. In the embodiment of Fig. 27, the interconnect structure is interconnected by programming (making conductive) selected antifuses to connect selected horizontal lines to selected vertical lines.

The context of antifuse programming will first be explained. Fig. 4 represents four cell blocks, each comprising 4 cells CELL_1 through CELL_4 positioned at the top of the block, 4 cells CELL_5 through CELL_8 positioned at the bottom of the block, and a ninth cell CELL_9 positioned along the right margin of the block. Cells CELL_1 through CELL_8 are as shown in Fig. 3. The ninth cell CELL_9 comprises 14 CCU cells such as shown in Fig. 10A or 10B. Additional horizontal lines extending through cell CELL_9 are horizontal interconnect lines of various lengths available for forming paths between logic cells of the array. Fig. 4 represents such an array. At intersections of horizontal and vertical lines are antifuses.

An antifuse is programmed by applying two sufficiently different programming voltages to one horizontal line and one vertical line intersecting at the antifuse. Fig. 12 shows a simplified representation of the antifuse programming path created by two circuits shown in Fig. 10A. When two different CCU units (see Figs. 10A and 10B) apply sufficiently different values of VPPL to their respective interconnect lines I, the voltage difference applied across an antifuse in the interconnect structure is sufficient to program the antifuse. Fig. 12 shows antifuse A1 which is programmed by applying a first programming voltage VPPLa through transistor 813a as controlled by a voltage on node N1a (equivalent to node N1 in Figs. 10A or 10B) to interconnect line segment Ia which contacts one terminal of antifuse A1. A second programming voltage VPPLb, shown as ground, is applied through transistor 813b to interconnect line Ib, which contacts the other terminal of antifuse A1. The voltage difference, for example 10 volts, is sufficient to program antifuse A1. A high impedance or an intermediate voltage applied to all other horizontal and vertical lines assures that at one time only a single antifuse receives sufficient voltage for programming.

First Embodiment Antifuse Programming Unit 810

Application of the programming voltages to the two terminals of an antifuse is controlled from circuit 810 of Fig. 10A. By shifting a pair of logical 1's through the shift register including inverters INV1 and INV2 only to the two CCUs which contact the interconnect lines I which cross and therefore contact the antifuse to be programmed; then applying different voltages to the two lines VPPL which connect to the two interconnect lines I, and then applying a low enable voltage $\overline{EN}$, the programming voltage will be applied across the addressed antifuse.

Thus the first step in programming an antifuse is to shift a pair of logical 1's into their respective CCUs.

In order to program the selected antifuse, transistor 813 connects a programming voltage source VPPL to an interconnect line. Two different programming voltage sources must be connected to the two different terminals of the antifuse. Therefore two different VPPL lines are connected to the CCU's which contact the horizontal and vertical interconnect lines. Different programming voltages are applied to these two different VPPL lines. In one embodiment, the two programming voltages differ by about 10 volts.

After the two logical 1's representing the two terminals of the antifuse to be programmed have been loaded through the shift register into their respective CCUs, the global signal $\overline{EN}$ is brought low, which turns off N-channel transistor 812 and turns on transistor 811, a P-channel transistor with a well at the VGLI voltage. The VGLI voltage should be at least one threshold drop $V_t$ above the higher programming voltage VPPL so that transistor 813 will not cause a voltage drop for this high programming voltage. The low $\overline{EN}$ voltage is applied to all CCUs in the chip, turning on transistor 811 and turning off transistor 812. All CCUs except those related to the antifuse to be programmed carry a logical 0, or low voltage, so most transistors 813 will remain off when the Q output voltage is applied to the gate of transistor 813. For the two CCUs storing a logical 1, the high voltage provided by transistor 811 to the gate of 813 turns on 813, causing the VPPL voltage to be applied to interconnect I. For these two CCUs, one of the VPPL signals is a high programming voltage and one is low, so that the related antifuse experiences the high voltage difference, and becomes permanently conductive. After a short programming period, $\overline{EN}$ is again brought high, turning off transistor 811, turning on transistor 812, and therefore turning off programming transistor 813.

The above process of loading the shift register and applying the programming voltage difference is repeated for every antifuse to be programmed.

Configuration Control Unit, Second Embodiment

Figure 10B shows a second embodiment of a configuration control unit employing a charge pump. In this embodiment, circuit 910 conditionally applies the programming voltage VPPL to the gate of transistor 813, as determined by the states of the Q and $\overline{Q}$ signals and the EN signal.

Circuit 910 includes a well known charge pump consisting of transistors 915, 916, and 917 (configured as a capacitor). An oscillating waveform on signal PHIP serves to inject charge onto node N1. The voltage on node N1 reacts to this charge injection and to the states of transistors 911, 912, and 914, which are controlled by the EN, Q and $\overline{Q}$ signals. As outlined in Table I, only when Q and EN are both logical 1 is N1 allowed to charge up.

Table I

| Q/$\overline{Q}$ | EN | 911 | 912 | 914 | N1 | 813 |
|---|---|---|---|---|---|---|
| 0/1 | 0 | off | on | on | held to ground by 914, 912 | off |
| 1/0 | 0 | on | on | off | held to ground by 911 | off |
| 0/1 | 1 | off | on | on | held to ground by 914, 912 | off |
| 1/0 | 1 | off | on | off | allowed to charge to VPPL + Vt | on |

Use of the circuit in Fig. 10B for programming interconnect is achieved by holding EN low while shifting a data pattern through the CCUs. With EN low, transistor 813 is off regardless of the state of Q/$\overline{Q}$. A low EN signal provides a means to shift data without inadvertently turning on transistor 813. The data pattern typically consists of all 0's except for two 1's corresponding to the two interconnect segments to be connected through an antifuse. Once the data pattern is in place, EN is brought high, allowing the CCUs (typically two) with a high Q state to charge up node N1 and turn on transistor 813. This transfers the programming voltage VPPL to the selected interconnect line connected to node I of Fig. 10B. When programming is completed, EN is again brought low, discharging node N1. This process is repeated for each antifuse to be programmed.

Other embodiments of the invention will become obvious to those skilled in the art in light of the above description. These other embodiments are intended to fall within the scope of the present invention.

## Claims

1.  A configuration control system for controlling configuration of configurable logic cells and a configurable interconnect structure in a field programmable gate array (FPGA) and for reading the status of signals on interconnect lines in the interconnect structure, the control system comprising:
    a plurality of configuration control units (CCU) each comprising:
    memory means (INV1,INV2) joined to memory means in another configuration control unit as a shift register; and
    means (802) for loading each of the memory means with a signal on a corresponding interconnect line.

2.  A control system as claimed in claim 1 comprising:
    means (810) for controlling application of a programming voltage to the corresponding interconnect line.

3.  A control system as claimed in claim 2 in which each memory means comprises a pair of serially connected inverters (INV1,INV2) which may be selectively connected together in a feedback (806,805) to form a static memory cell.

4.  A control system as claimed in claim 3 in which each inverter is powered by a supply voltage (VGLI) at least as high as the programming voltage.

5.  A configuration control system for controlling configuration of configurable logic cells in a field programmable gate array (FPGA) comprising configurable logic cells and a configurable interconnect structure, the control system comprising:
    a plurality of configuration control units (CCU) each comprising:
    memory means (INV1,INV2) joined to memory means in another configuration control unit as a shift register; and
    means (Q, 810) for performing one of two functions, namely, controlling configuration of part of one of the configurable logic cells from content of the memory means, and controlling application of a programming voltage to an interconnect line in the interconnect structure from content of the memory means.

6.  A configuration control unit in a field programmable gate array (FPGA) comprising configurable logic cells and a configurable interconnect structure, the control unit comprising;
    memory means (INV1,INV2) which may be loaded and read, the memory means providing a stored value (Q); and
    means (810) for controlling application of a programming voltage to the corresponding interconnect line (I) comprising:
    means (813) for supplying a programming voltage (VP) to the corresponding interconnect line (I) and means (EN-bar, 812,811) for controlling the means for supplying;
    whereby when the stored value (Q) is a select voltage (high), and the means for controlling (EN-bar, 811,812) selects the stored value, the means (813) for supplying a programming voltage supplies the programming voltage (VP) to the corresponding interconnect line (I).

7.  A control unit as claimed in claim 6 in which the means for controlling (EN, 812,811) comprises:
    means (811) for supplying the stored value;
    means (812) for supplying a disable voltage (gnd); and
    means (EN) for causing the means for controlling to select between applying the disable voltage (gnd) to the means for supplying and applying the stored value (Q) to the means for supplying.

8. A method of configuring a field programmable gate array (FPGA) comprising:

configurable logic cells configured by values in configuration memory cells, and

a configurable interconnect structure comprising horizontal and vertical interconnect lines, the interconnect structure being configured by programming antifuses at intersections of the horizontal and vertical interconnect lines under control of the values in the configuration memory cells and of means (810) for controlling application of a programming voltage to the corresponding interconnect line, and

a plurality of programming voltage lines, each connectable to one terminal of a plurality of antifuses, such that opposite terminals of any antifuse are connectable to different ones of said programming voltage lines;

the method of configuring the FPGA comprising the steps of:

for each antifuse to be programmed:

1) loading a pair of 1's into two CCU's which control forwarding of programming voltages to horizontal and vertical lines intersecting at terminals of said antifuse to be programmed;

2) applying two different programming voltages to programming voltage lines forwarded by said two CCU's;

3) apply a programming control signal (EN) to said means (810) for controlling application of a programming voltage to said corresponding interconnect line, thereby causing a programming voltage to be applied across said antifuse to be programmed;

until all antifuses have been programmed,

thereby configuring said interconnect structure.

9. A method as claimed in claim 8 in which the step of loading is implemented through a shift register.

10. A method as claimed in claim 8 or 9 in which the method of configuring the FPGA comprises the further step, performed after all antifuses have been programmed, of shifting a bit stream through a shift register in which CCUs are connected to cause each CCU to store a logical value which configures part of a logic cell with which the CCU is associated.

11. A method as claimed in claim 10 comprising the further steps, performed after the bit stream is shifted through the shift register in which CCUs are connected, of:

substituting for a value loaded into each CCU a value present on an interconnect line with which the CCU is associated; and

shifting values substituted into each CCU out of the FPGA through the shift register.

12. A method of capturing data present on interconnect lines of a field programmable gate array (FPGA) comprising:

a plurality of configuration memory cells each having an input port and an output port and each comprising first and second inverters which are programmably connectable into a loop, the memory cells being programmably connectable together as a shift register by connecting the output of the second inverter of one memory cell to the input of the first inverter of another memory cell; and

a configurable interconnect structure comprising interconnect lines, each of the interconnect lines being programmably connectable to an input port of one of the configuration memory cells;

the method comprising the steps of:

1. disconnecting the first inverters from the second inverters;

2. programmably connecting the interconnect lines to their respective first inverters;

3. programmably connecting the outputs of the first inverters to the inputs of the second inverters;

4. programmably disconnecting the interconnect lines from their respective first inverters;

5. programmably connecting the outputs of the second inverters to the inputs of the first inverters; and

6. shifting data through the shift register;

whereby data present on the interconnect lines is shifted out of the shift register.

13. A method as claimed in claim 12 in which the steps are performed in the order stated, or in which the step 4 is performed before the step 3.

**14.** A method as claimed in claim 12 or 13 in which the FPGA comprises:

a plurality of logic cells each including means for providing a high impedance output, each of the configuration memory cells being connected to one of the logic cells, and in which

the method comprises the step of causing each of the logic cells to provide a high impedance output before the step of programmably connecting the outputs of the first inverters to the inputs of the second inverters.

FIG. 1
(PRIOR ART)

FIG. 2
(PRIOR ART)

EP 0 581 409 A1

# FIG. 3

FIG. 4

CELL_1 CELL_2 CELL_3 CELL_4

CELL_5 CELL_8 CELL_9

14

MULTIPLEXER

# FIG. 5A

# FIG. 5C

MULTIPLEXER

# FIG. 5B

# FIG. 6A   SET / RESET LATCH

# FIG. 6B

4-INPUT AND GATE
1 INVERTED INPUT

## FIG. 7A

## FIG. 7C

1=INV
0=NONINV

0=NOR
1=NAND

## FIG. 7B

8-INPUT AND

**FIG. 8A**

**FIG. 8C**

**FIG. 8B**

**FIG. 9A**
D FF
WITH RESET

**FIG. 9C** D FLIP FLOP WITH RESET
CLOCK/RESET POLARITY PROGRAMMABLE

**FIG. 9B**     D FLIP FLOP WITH RESET

FIG. 10A

EP 0 581 409 A1

FIG. 10B

PHI (805)

PHIB (801)

PHIH (806)

PHIC (802)

$\overline{\text{GTS/QOE}}$

1    2    3    4    5    6

←——————10-1000 us——————→

CAPTURE TIMING

# Fig. 11

VPPLa

N1a — 813a — Ia

(INTERCONNECT)

A1

(INTERCONNECT)

Ib

N1b — 813b

= VPPLb

# FIG. 12

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PROCEEDINGS OF THE IEEE 1990 CUSTOM INTEGRATED CIRCUITS CONFERENCE 13 May 1990, BOSTON, MA, US pages 31.2.1 - 31.2.7 H.-C. HSIEH ET AL 'Third-generation architecture boosts speed and density of Field-Programmable Gate Arrays' * the whole document * | 1,5,6,8 | H03K19/177 H03K19/173 |
| A | EP-A-0 410 759 (XILINX INC.) * column 7, line 33 - column 13, line 58; figures * | 1,5,6,8 | |
| A | US-A-4 872 137 (JENNINGS) * column 2, line 41 - column 6, line 55; figures 1-7,20 * * column 9, line 60 - column 10, line 7 * | 1,5,6,8, 9 | |
| A | US-A-4 758 985 (CARTER) * column 2, line 43 - column 14, line 58; figures 2,4A-11 * | 1,5,6,8, 12 | |

TECHNICAL FIELDS SEARCHED (Int. Cl.5 )

H03K

The present search report has been drawn up for all claims

| Place of search | Date of completion of the search | Examiner |
|---|---|---|
| BERLIN | 03 NOVEMBER 1993 | TAYLOR P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)